# EUROPEAN PATENT APPLICATION

(11) **EP 2 123 913 A1**
(43) Date of publication of application: **25.11.2009**
(21) Application number: 08720932.6
(22) Date of filing: 27.02.2008
(51) Int. Cl.: F04B 43/04, F04B 45/047, H01L 41/09

(54) **FLUID TRANSPORTATION DEVICE**

(30) Priority: 12.03.2007 JP 2007061703
(71) Applicant: Murata Manufacturing Co. Ltd., Kyoto 617-8555 (JP)
(72) Inventor: KAMITANI, Gaku, Nagaokakyo-shi Kyoto 617-8555 (JP); HIRATA, Atsuhiko, Nagaokakyo-shi Kyoto 617-8555 (JP)
(74) Representative: Reeve, Nicholas Edward
(86) International application number: PCT/JP2008/053384
(87) International publication number: WO 2008/111397

(57) **Abstract**

[Object] To provide a fluid conveyance device having a simple and compact structure and conveying efficiently a fluid.

[Solving Means] A fluid conveyance device includes a substrate 10, and a disk-like piezoelectric element 20 arranged in a bendable fashion on the substrate. A plurality of circular concentric segment electrodes 23a-23e are formed on the piezoelectric element 20, and are provided with voltages E1-E4 with phases thereof shifted. A ring wavy deformation is thus caused on the piezoelectric element 20. A ring pocket caused between the piezoelectric element 20 and the substrate 10 is moved in a radial direction, conveying a fluid from an outer circular portion to a central portion and discharging the fluid from the central portion.

## Description

### Technical Field

The present invention relates to fluid conveyance devices and, in particular, to a fluid conveyance device employing a bend-deformable piezoelectric element.

### Background Art

A piezoelectric pump is used as a coolant water pump for a compact electronic apparatus, such as a notebook personal computer, a fuel transport pump for a fuel cell, or the like. The piezoelectric pump is also used as a fan pump replacing a cooling fan for a CPU or the like, or a fan pump for supplying oxygen required by a fuel cell that generates power. The piezoelectric pump is a pump that employs a piezoelectric element that bends a shape thereof in response to voltage application. The advantage of the piezoelectric pump is a simple and thin structure and a low power consumption.

Patent Documents 1 and 2 propose a piezoelectric pump. In the piezoelectric pump, a vibration plate is placed into contact with a pump body having an inlet port and an outlet port, and a plurality of piezoelectric elements are lined from the inlet port to the outlet port on the vibration plate. In this pump, when the piezoelectric elements from the inlet portion to the outlet port are successively driven, the vibration plate is bent, one portion after another, from the inlet port to the outlet port so that a fluid is pushed from the inlet port to the outlet port. When voltage application to the piezoelectric element stops, a flow flow passage between the inlet port and the outlet port is closed in response to a recovery of the vibration plate. Therefore, check valve between the inlet port and the outlet port is thus omitted.

In the case of the above-described related art, the piezoelectric pump includes the plurality of bonded piezoelectric elements with voltages different in phases applied thereto, and thus operates as a so-called tube pump which conveys a fluid from one end to the other end of the pump body. Since the plurality of piezoelectric elements are arranged in a flat plane, the pump becomes bulky and complex in structure. Since the plurality of piezoelectric elements operate in a tube-pump mode, the structure of an elastically deformable joint connecting the piezoelectric elements and sealing of the fluid are difficult problems. A mechanism for conveying a miniature volume pocket holding the fluid is difficult to implement.

Patent Document 3 discloses one fluid pump which has ring segment electrodes formed on each of a central portion and a periphery portion of a piezoelectric element. The central portion and the periphery portion are expanded and contracted in opposite directions to bend the piezoelectric element and thus functions as a pump to convey a fluid. The piezoelectric element is rectangular, and segment electrodes are lined in a longitudinal direction of the piezoelectric element. In this case, as well, the bending shape of the piezoelectric element is in a so-called tube-pump mode in which the piezoelectric element bends from one end to the other end. As with the above-described related art, a plurality of electrodes need to be lined in the direction of motion, and the pump becomes bulky in structure. Sealing of a joint connecting the elastically deformable electrodes is difficult.
A miniature volume pocket containing the fluid is difficult to convey.
Patent Document 1: Japanese Unexamined Patent Application Publication (Translation of PCT Application) No. 2-149778
Patent Document 2: Japanese Unexamined Patent Application Publication (Translation of PCT Application) No. 4-86388
Patent Document 3: Japanese Unexamined Patent Application Publication (Translation of PCT Application) No. 1-500892

### Disclosure of Invention

### Problems to be Solved by the Invention

It is an object of the preferred embodiments of the present invention is to provide a simple and compact structured fluid conveyance device conveying efficiently a fluid.

### Means for Solving the Problems

To achieve the above object, the present invention provides a fluid conveyance device including a substrate, and a disk-like piezoelectric element arranged in a bendable fashion on the substrate. A plurality of circular concentric segment electrodes are provided on the piezoelectric element. Voltage application means applying voltage to the segment electrodes with the voltage successively shifted in phase is arranged. The voltages are applied to the segment electrodes with the phase thereof shifted to cause a ring wavy deformation on the piezoelectric element and move in a radial direction a ring pocket caused between the piezoelectric element and the substrate so that a fluid is conveyed between an outer circular potion and a central portion of the substrate.

In accordance with the present invention, the disk-like piezoelectric element having the plurality of circular concentric segment electrodes formed on the substrate is arranged. The substrate and the piezoelectric element are in contact with almost no gap therebetween when no voltage is applied to the piezoelectric element. When the segment electrodes are applied with voltages of the same amplitude shifted in phase, a ring wavy bend-deformation takes place on the piezoelectric element. The ring wavy deformation causes a ring pocket between the piezoelectric element and the substrate. The ring pocket moves in a radial direction from the outer circular portion to the inner circular portion or from the inner circular portion to the outer circular portion, thereby conveying the fluid between the outer circular portion and the central portion. Since the ring pocket holding the fluid is sealed by the piezoelectric element itself, leaking of the fluid is minimized. The fluid within the pocket is steadily conveyed, and a high ejection pressure is thus generated. Since the piezoelectric element has a disk shape with the segment electrodes concentric, a simple and compact structured device is achieved.

The fluid conveyed by the fluid conveyance device of the present invention may be a liquid or a gas (such as the air). In particular, if the piezoelectric element is driven at a high frequency, the use of a gas is advisable. In the case of the air, the fluid conveyance device may be used for a cooling blower for semiconductor devices or a blower for evaporating water generated at an air electrode of a fuel cell. It is not necessarily required that the amplitudes of the voltages applied to the segment electrodes be equal at all the segment electrodes. However, if the amplitudes of the voltages are set to be equal to each other, the amount of displacement of the each segment electrodes are set to be substantially equal. If the gaps between the segment electrodes are radially arranged with an equal pitch, the volume of the pocket is changed at a substantially constant rate, and the flow of the fluid becomes smooth.

Preferably, a first flow passage port is formed on the central portion of one of the substrate and the piezoelectric element, and a second flow passage port is formed on the outer circular portion of one of the substrate and the piezoelectric element or between the outer circular portions of both the substrate and the piezoelectric element. The reversal of the phases of the voltages applied to the piezoelectric element switches between an operation for suctioning the fluid from the outer circular portion and then ejecting the fluid from the central portion and an operation for suctioning the fluid from the central portion and ejecting the fluid from the outer circular portion. More specifically, a switching operation is performed to switch between an operation with the first flow passage port serving as a outlet port and the second flow passage port serving as an inlet port and an operation with the first flow passage port as an inlet port and the second flow passage port as a outlet port. In particular, in the former case (in the operation with the fluid suctioned through the outer circular portion and then ejected through the central portion), the pocket decreases in volume as the pocket moves from the outer circular portion to the central portion. An ejection pressure is thus advantageously increased.

Preferably, the outer circular portion of the piezoelectric element is fixed to the substrate, and the first flow passage port and the second flow passage port are closed by the piezoelectric element and the substrate.
Since the first flow passage port and the second flow passage port are closed with no voltage applied, the flow of the fluid is stopped without any particular valve.

The full surface of the piezoelectric element may be in contact with the full surface of the substrate when no voltage is applied to the piezoelectric element. In such a case, no pocket is present between the piezoelectric element and the substrate during no drive period, the fluid is strongly suctioned and then strongly ejected even if the piezoelectric element is slightly displaced.

In a structure supporting the piezoelectric element to the substrate, the outer circular portion of the piezoelectric element may be fixed to the substrate or may be elastically supported by the substrate. In the former case, the outer circular portion of the piezoelectric element is fixed to the substrate, and the piezoelectric element is prevented from lifting off. The efficiency of the pump is increased. In the latter case, the outer circular portion of the piezoelectric element is bent, naturally causing a second flow passage port between the piezoelectric element and the substrate. The piezoelectric element, not strongly bound, is free to be displaced. Any optional support structure may be applied to the piezoelectric element.

The piezoelectric element is preferably a multilayer type having a bimorph structure. For example, the piezoelectric element may be a multilayer type in which at least three circular concentric segment electrodes and a full-surface nonsegmented electrode are alternately laminated with a piezoelectric layer interposed therebetween. The piezoelectric element may be a multilayer type in which a plurality of first circular concentric segment electrodes and a plurality of second segment electrodes are alternately laminated with a piezoelectric layer interposed therebetween, and wherein the second segment electrodes are concentric with the first segment electrodes and gaps between the second segment electrodes are alternately formed with a gap between the first segment electrodes in a radial direction. In the former case, one electrode is a whole-area electrode (full-surface electrode), and the types of electrode patterns are one type only. The latter case provides the advantage that the number of segment electrodes on a per surface can be less than that of the former case, and that the voltage applied to each segment electrode can be lowered.

It is not required that the segment electrodes arranged on the disk-like piezoelectric element be circular concentric. The plurality of segment electrodes may be successively decentered to one side. More specifically, if the diameter of the piezoelectric element is reduced for miniaturization, the volume of the pocket formed in a circular shape is reduced in proportion to the diameter of the piezoelectric element approximately to the fourth power. An ejection amount of the fluid thus substantially decreases. In contrast, if the plurality of segment electrodes are successively decentered to one side, each segment electrode has both a wide portion and a narrow portion. The volume of the pocket is still assured in the wide portion of the each segment electrode. Even if the diameter of the piezoelectric element is decreased, the reduction of the volume of the pocket is limited, and an excessive reduction in the ejection amount is also limited.

If the height of the ridge line of the bend-deformation is not uniform with the decentered segment electrodes, a clearance gap can open at the edge of the pocket, leading to poor sealing. A required amount of flow and pressure of the fluid cannot be obtained. The border line of each electrode needs to be determined so that the electrode patterns make the height of the ridge line uniform. For this reason, the border line of the electrode, i.e., the gap between the electrodes is preferably set to be substantially proportional to the square root of a distance to an imaginary straight line placed on a circle outside the piezoelectric element. In this case, lines connecting the imaginary straight line to the peak of each swell portion are aligned on a plane. Each pocket is thus steadily sealed, and the fluid can be steadily conveyed.

In the above-description, the piezoelectric element is arranged in a bendable fashion on the fixed substrate. The substrate may be a piezoelectric element. More specifically, two disk-like piezoelectric elements are arranged to face each other, and then symmetrically displaced. In this case, the volume of the pocket swell is doubled, increasing the ejection amount.

### Advantages of the Preferred Embodiments of the Invention

In accordance with the present invention, the disk-like piezoelectric element having the plurality of circular concentric segment electrodes is arranged on the substrate. The voltages are applied to the segment electrodes with the voltages successively shifted in phase. The piezoelectric element is thus bent-deformed, forming the ring pocket between the piezoelectric element and the substrate. By moving the pocket in a radial direction, the fluid is radially conveyed. Since the piezoelectric element has a disk-like shape, and the segment electrodes are concentric, the ring pocket holding the fluid is sealed with the piezoelectric element itself, and a high ejection pressure results. Since the fluid conveyance device includes the single disk-like piezoelectric element and the substrate, the device can be simple, compact and thin structure. Furthermore, since the flow passage between the inlet port and the outlet port is closed by the bent piezoelectric element, check valves for the inlet port and the outlet port can be omitted.

### Best Mode for Carrying Out the Invention

The preferred embodiments of the present invention are described below with reference to examples.

### Embodiment 1

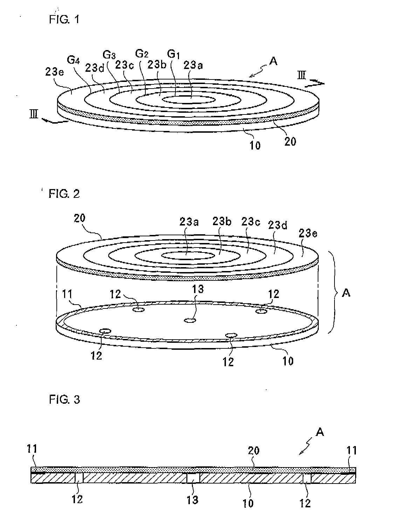

Figs. 1-3 illustrate a first embodiment of a fluid conveyance device of the present invention. Here, the fluid conveyance device is used as an air supplying micro pump. Fig. 1 is a perspective view of the micro pump A of the first embodiment, Fig. 2 is an exploded perspective view of the micro pump A, and Fig. 3 is a sectional view taken along line III-III in Fig. 1.

The micro pump A of the first embodiment includes a substrate 10 as a fixed plate, and a disk-like piezoelectric element 20 arranged in a bendable fashion on the substrate 10. A whole outer circular portion of the piezoelectric element 20 is bonded to the piezoelectric element 20 by an adhesive agent 11. In accordance with the first embodiment, the substrate 10 and the piezoelectric element 20 are disks having the same diameter. The substrate 10 has any optional shape and may be larger than the piezoelectric element 20. The substrate 10 is a rigid metal plate or a resin plate, and has on the top portion thereof a planar material member in contact with the piezoelectric element 20. A plurality of inlet ports 12 are formed in a portion of the substrate 10 slightly more inside than the outer circular portion where the adhesive agent 11 is applied. A outlet port 13 is formed in a portion of the substrate 10 facing the center of the piezoelectric element 20. Alternatively, the inlet ports 12 and the outlet port 13 may be formed on the piezoelectric element 20 instead of the substrate 10 or the inlet ports 12 may be formed in the form of grooves on the top surface of the substrate 10 that communicate with the outer circular portion of the micro pump A. As illustrated in Fig. 3, the entire surface of the substrate 10 is in contact with the entire surface of the piezoelectric element 20 with no voltage applied to the piezoelectric element 20, and no pocket (cavity) is presented therebetween and the inlet ports 12 and the outlet port 13 are thus closed.

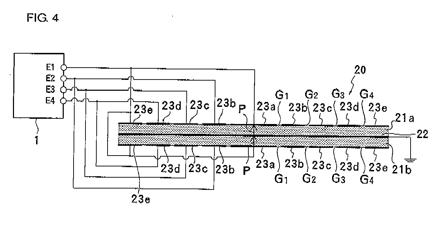

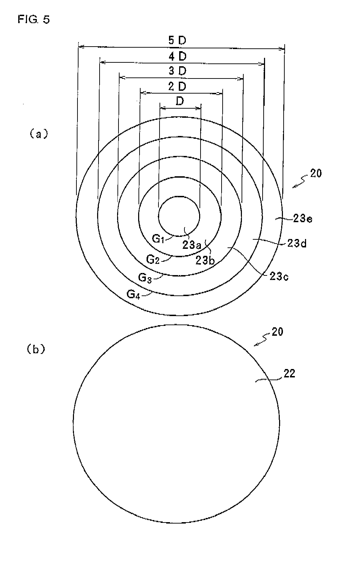

Figs. 4 and 5 illustrate a detailed structure and wiring structure of the piezoelectric element 20. With reference to Fig. 4, the piezoelectric element 20 includes two piezoelectric layers 21a and 21b laminated with a full-surface electrode 22 interposed therebetween. The two piezoelectric layers 21a and 21b are entirely polarized in the same direction as denoted by an arrow P. Five segment electrodes 23a-23e are split by narrow gaps G1-G4 and concentrically formed on the top and bottom main surfaces of the piezoelectric element 20. The segment electrodes 23a-23e include the first circular segment electrode 23a centered on the piezoelectric element 20, and second through fifth ring segment electrodes 23b-23e placed outside the first circular segment electrode 23a. The first central segment electrode 23a formed in the center portion is connected to the fifth segment electrode 23e formed in the most outer circular potion. The segment electrodes 23a-23e on the bottom surface are also equally constructed. The segment electrodes facing each other on the top and bottom surfaces are respectively connected each other, and are then connected to voltage application means 1. Referring to Fig. 4, the voltage application means 1 applies a voltage E1 to the first and fifth segment electrodes 23a and 23e, a voltage E2 to the second segment electrodes 23b, a voltage E3 to the third segment electrodes 23c, and a voltage E4 to the fourth segment electrodes 23d. The full-surface electrode 22 is connected to the ground, namely, to zero V.

In the first embodiment, the gaps G1-G4 between the segment electrodes are arranged in circles with equal pitch. More specifically, as illustrated in Fig. 5, let D represent a diameter D of the gap G1 between the first segment electrode 23a and the second segment electrode 23b, the diameter of the gap G2 between the second segment electrode 23b and the third segment electrode 23c is 2D, the diameter of the gap G3 between the third segment electrode 23c and the fourth segment electrode 23d is 3D, the diameter of the gap G4 between the fourth segment electrode 23d and the fifth segment electrode 23e is 4D, and the external diameter of the fifth segment electrode 23e (external diameter of the piezoelectric element 20) is 5D.

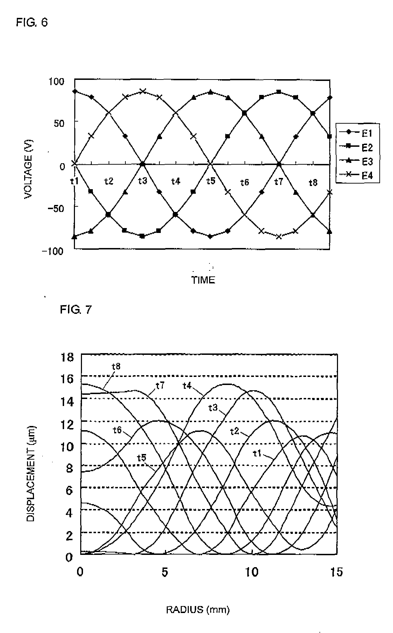

Fig. 6 illustrates amplitudes and phases of the voltages E1-E4 the voltage application means 1 applies respectively to the segment electrodes. With reference to Fig. 6, the sinusoidal wave voltages E1-E4 different in phase by 90 degrees having the same amplitude are applied. By applying the voltages different in phase by 90 degrees, displacements illustrated in Fig. 7 are generated on the piezoelectric element 20. The voltages different in phase by 90 degrees are applied to the four segment electrodes in the first embodiment. The phase may be changed depending on the number of segment electrodes. For example, the voltages different in phase by 120 degrees may be applied to three segment electrodes, and the voltages different in phase by 60 degrees may be applied to six segment electrodes.

Fig. 7 illustrates simulation results of the displacement of each portion of the piezoelectric element 20 with the outer circular portion not fixed. The piezoelectric element 20 used here has a diameter of 30 mm and a thickness of 0.3 mm. The abscissa of Fig. 7 represents position in a radial direction and the ordinate represents a displacement of bend-deformation in a Z direction (height direction). The lowest positions are aligned with zero. Represented by tl-t8 are phases of sinusoidal waves shifted in steps of 45°, and eight curves represent displacements when the voltages are applied to the respective electrodes with the phases thereof shifted by 45°. The position at zero displacement is presumed to be at a facing floor surface (the substrate 10). The piezoelectric element is placed into contact with the floor surface at a diameter of 12.5 mm slightly beyond phase t5, and a central contact point and a contact position are reversed. In this way, a pocket holding the fluid appears at the center between the floor surface and the piezoelectric element. The central pocket decreases in volume as time passes in the order of t5 - t6 - t7 - t8 - t1 - t2, and finally disappears.

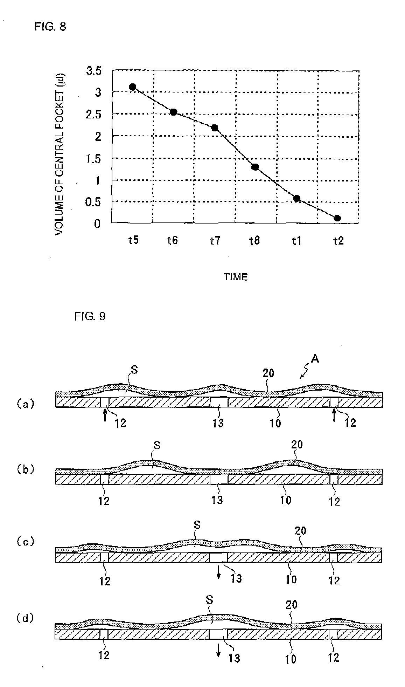

Fig. 8 illustrates a change in the volume of the central pocket. It is understood from Fig. 8 that the volume of the central pocket decreases at a substantially constant rate. If a hole 13 is opened at the center of the floor surface (the substrate 10), the fluid can be ejected through the hole in the process of t5 - t6 - t7 - t8 - t1 - t2 - t3. In a subsequent process of t4 - t5, the suction of a new fluid input from the outer circular portion is completed. This process is repeated hereinafter. By driving the piezoelectric element 20 with an adequate frequency, a large ejection quantity is obtained on average, although with a fluctuation involved. The resonance frequency of the piezoelectric element 20 of the first embodiment is 4 kHz, and a frequency as high as possible but not above the resonance frequency is preferably used.

Fig. 9 illustrates an actual displacement of the piezoelectric element 20 with the outer circular portion fixed. With the sinusoidal wave voltages E1-E4 different in phase by 90° and having the same amplitude applied, a wavy bend-deformation occurs in a radial direction on the piezoelectric element 20 and a pocket S having a ring shape is caused between the piezoelectric element 20 and the substrate 10 as illustrated in Fig. 9. The pocket S moves from the outer circular portion to the central portion on the piezoelectric element 20. For this reason, the fluid is suctioned through the inlet ports 12 on the outer circular portion and then discharged through the outlet port 13 on the central portion. Fig. 9(a) illustrates a state of the piezoelectric element 20 in which the ring pocket S is generated on the outer circular portion. The fluid is suctioned through the inlet ports 12 and then enters the pocket S. Fig. 9(b) illustrates a state of the piezoelectric element 20 in which the ring pocket S generated on the outer circular portion moves toward an inner circle with the inlet ports 12 and the outlet port 13 almost closed. In this state, the outer circle and the inner circle of the pocket S holding the fluid are sealed in response to the bend of the piezoelectric element 20, and an amount of leaks of the fluid is small. Fig. 9(c) illustrates a state of the piezoelectric element 20 in which the pocket S further shifts to an inner circle until the pocket S becomes merged at the center, and the ejection of the fluid through the outlet port 13 starts. Fig. 9(d) illustrates a state of the piezoelectric element 20 in which the bend of the piezoelectric element 20 shifts further to an inner circle until the displacement at the center thereof becomes maximized. The piezoelectric element 20 returns to the state of Fig. 9(a) and the ejection of the fluid through the outlet port 13 continues until the state of Fig. 9(a) resumes.

The micro pump A has the above-described structure that causes the fluid to be suctioned through the inlet ports 12 formed at the outer circular portion and ejects the fluid through the outlet port 13 formed at the center portion. In this case, the ring pocket S shifts from the outer circular portion to the central portion with the volume thereof gradually decreased, and then causes the fluid to eject through the outlet port 13 at the center at a burst. Therefore, the ejection pressure of the fluid to be ejected through the outlet port 13 is thus increased. During nondrive period, the surface of the piezoelectric element 20 remains in contact with the surface of the substrate 10, causing no pocket. If the piezoelectric element 20 is slightly displaced, the fluid can be sectioned, and then can be ejected at a high pressure.

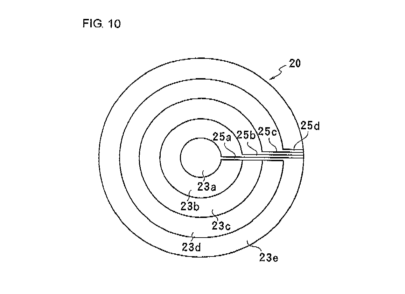

Fig. 10 illustrates one example of an electrode structure that routes to the outside the segment electrodes 23a-23e formed on the top and bottom surfaces. Referring to Fig. 10, an extension electrode 25a extending radially from the first segment electrode 23a at the center to the outer circle edge is formed. In parallel with the extension electrode 25a, extension electrodes 25b-25d extending radially from the second - fourth segment electrodes 23b-23d to the outer circle edge are formed. The extension electrode 25a extending from the first segment electrode 23a is connected to the fifth segment electrode 23e on the main surface. Alternatively, the extension electrode 25a may be separated from the fifth segment electrode 23e. The segment electrodes 23a-23e both on the top surface and the bottom surface are extended to the outer circle edge and can be connected together by an edge electrode (not shown).

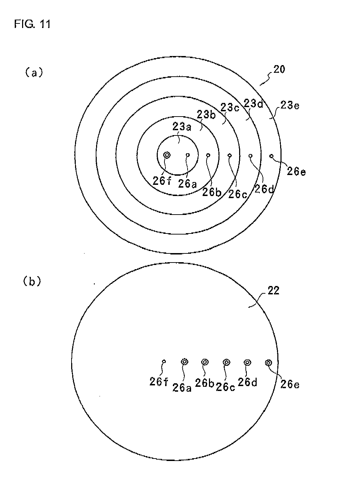

If the piezoelectric element 20 has a multi-layered structure, through-holes 26a-26f may be used to connect the segment electrodes 23a-23e on the top and bottom surfaces as illustrated in Fig. 11. The through-holes 26a-26e are through-holes respectively connecting the segment electrodes 23a-23e on the top surface to the counterparts on the bottom surface, and the through-hole 26f is a through-hole connecting the full-surface electrodes. In this case, electrode extensions are required only at the through-hole portion, and a deformation can be caused in a shape closer to an axial symmetrical shape.

If the piezoelectric micro pump A thus constructed is arranged in a manner such that the outlet port 13 faces a heat generating element (such as a semiconductor bare chip), air pushed out through the outlet port 13 can effectively cool the heat generating element. If the piezoelectric micro pump A is arranged to face an air electrode of a direct-methanol fuel cell, water generated at the air electrode is evaporated and thus removed. The output of the fuel cell is increased. In the case of a stacked fuel cell, a flow passage may be arranged so that air pushed out through the outlet port 13 flows between the cells, and water generated at the air electrode is evaporated and removed. The output of the fuel cell is increased.

### Embodiment 2

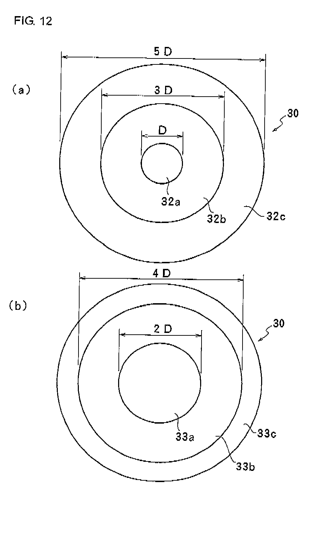

Figs. 12-14 illustrates a second embodiment of a fluid conveyance device of the present invention. Unlike the first embodiment, the second embodiment employs two different patterns as the segment electrodes of a piezoelectric element 30. With the diameter of the piezoelectric element 30 being 5D, a first electrode pattern includes three concentric circular segment electrodes 32a-32c segmented along a diameter D and a diameter 3D as illustrated in Fig. 12(a), and a second electrode pattern includes three concentric circular segment electrodes 33a-33c segmented along a diameter 2D and a diameter 4D as illustrated in Fig. 12(b).

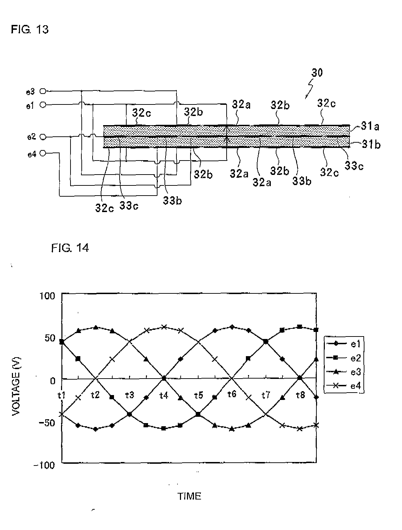

As illustrated in Fig. 13, two types of segment electrodes 32a-32c and 33a-33c are laminated with piezoelectric layers 31a and 31b interposed therebetween.
The segment electrodes 32a at the center are mutually connected to the outermost segment electrodes 32c, and the segment electrodes on the top surface are respectively connected the segment electrodes on the bottom surface. The interlayer segment electrodes 33a and 33c are connected to each other and an extension therefrom is routed to the outside. The interlayer segment electrode 33b is separately routed to the outside. Voltage application means not illustrated applies a voltage e1 to the segment electrodes 32a and 32c, a voltage e2 to the segment electrodes 33a and 33c, a voltage e3 to the segment electrode 32b, and a voltage e4 to the segment electrode 33b. Fig. 13 illustrates the example in which the first electrode pattern 32a-32c serve as the main surface electrodes, and the second electrode pattern 33a-33c serve as the interlayer electrodes. It is perfectly acceptable that the first electrode pattern 32a-32c serves as the interlayer electrodes, and the second electrode pattern 33a-33c serves as the main surface electrodes.

Fig. 14 illustrates the amplitude and phases of the voltage e1-e4 applied to the segment electrodes. As illustrated in Fig. 14, the sinusoidal wave voltages e1-e4 different from each other in phase by 90 degrees and having the same amplitude are applied to the segment electrodes, and a displacement similar to the displacement illustrated in Fig. 7 takes place on the piezoelectric element 30. In the first embodiment, the voltages E1-E4 having the phases thereof shifted by 90 degrees one from another are applied between the segment electrodes 23a-23e and the full-surface electrode 22 (0 V). In the second embodiment, the voltages e1-e4 having the phases thereof shifted by 90 degrees one from another are applied between the segment electrodes facing each other with the piezoelectric layer interposed therebetween. Even with the voltages e1-e4 smaller in amplitude than the voltages E1-E4, the same displacement amount results. The number of segment electrodes formed on one surface is smaller than in the first embodiment. In other words, the number of gaps defining the segment electrodes is reduced, and the piezoelectric element 30 is thus effectively bent.

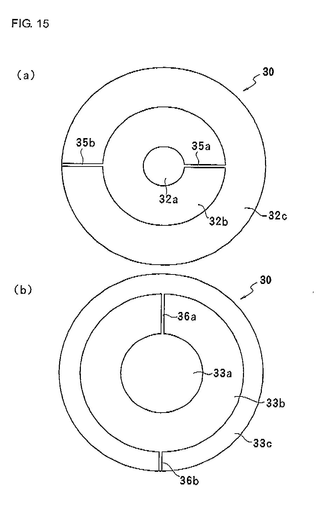

Fig. 15 illustrates one example of the structure that is intended to extend the segment electrode on the piezoelectric element 30 of the second embodiment. Referring to Fig. 15(a), out of the first electrode pattern 32a-32c, the central segment electrode 32a and the segment electrode 32c on an outer circular portion are connected to each other by an extension electrode 35a extending in a radial direction. Moreover, the intermediate segment electrode 32b is routed to an outer circular edge via an extension electrode 35b. Referring to Fig. 15(b), out of the second electrode pattern 33a-33c, the central segment electrode 33a and the segment electrode 33c on an outer circular portion are connected to each other by an extension electrode 36a extending in a radial direction. The intermediate segment electrode 33b is thus routed to an outer circular edge via an extension electrode 36b extending in a radial direction. The extension electrodes 35a and 35b and the extension electrodes 36a and 36b are formed in mutually perpendicular directions so that the extension electrodes may not cross each other. The electrodes extended to the outer circular edge are connected by an edge electrode (not shown).

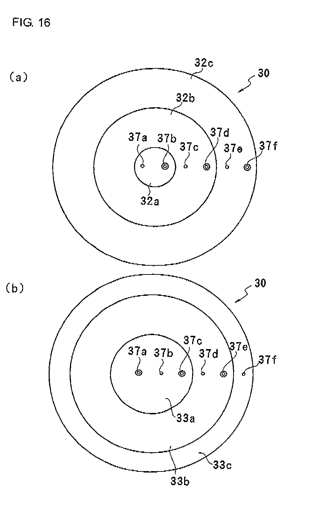

Figs. 16(a) and 16(b) illustrate the piezoelectric element 30 in which through-holes are substituted for the extension electrodes in a radial direction and the edge electrode illustrated in Fig. 15. More specifically, the first electrode patterns 32a-32c are respectively connected to each other and the second electrode patterns 33a-33c are respectively connected to each other by the though-holes 73a-37f. In this case, as well, electrode extensions are required only at the through-hole portion, and a deformation can be caused in a shape closer to an axial symmetrical shape.

### Embodiment 3

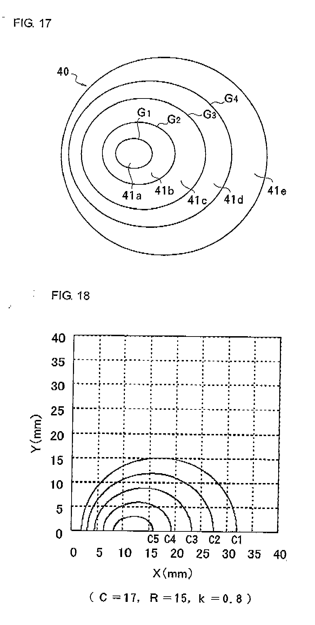

Figs. 17-19 illustrate a third embodiment of the fluid conveyance device of the present invention. In accordance with the present embodiment, the electrode patterns of a piezoelectric element 40 are not concentric, but are arranged in a decentered form as illustrated in Fig. 17. More specifically, ring segment electrodes 41b-41e are successively formed around a central segment electrode 41a in a decentered fashion. A pitch of gaps G4-G4 serving as border lines between the segment electrodes is set to be in proportion to the square root of a distance to an imaginary straight line O outside the piezoelectric element 40. In this example, the imaginary straight line O is x=0 (Y axis in Fig. 18). The border line pitch is set to be 0.8x^{0.5} so that the pitch is proportional to the square root of a distance x from the imaginary straight line O. If the diameter of the piezoelectric element 40 is 30 mm, the center of the piezoelectric element 40 is (x,y)=(17,0).

A displacement height h is approximately proportional to the square of the border line pitch (pitch of the gaps G1-G4) during deformation. Therefore, the volume of the pocket holding the air increases more with the electrodes arranged decentered than with the electrodes concentrically arranged. For this reason, the decentered electrodes are more advantageous in increasing the amount of flow of the fluid. However, if the height of the ridge of the deformation is not uniform, a clearance gap is opened at the edge of the pocket. As a result, the device suffers from poor sealing and lacks a flow amount and pressure. The border line thus needs to be determined so that an electrode pattern resulting in a uniform height of the ridge of the pocket is provided.

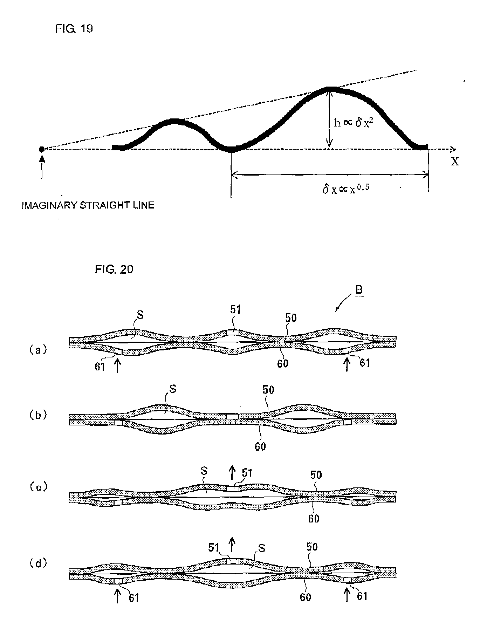

The displacement height h of the deformation is approximately proportional to the square of the border line pitch. If the border line pitch is set to be proportional to the square root of the distance from the imaginary straight line O outside the piezoelectric element, the height of the ridge is aligned in a single plane. If the border line pitch is selected as illustrated in Fig. 19 so that the border line pitch is proportional to the square root of the distance x from the imaginary straight line O, a **swell pitch** δx is proportional to the border line pitch. The swell pitch δx is also proportional to the square root of the distance x from the imaginary straight line O as below.
δx ∝ x^{0.5}
where the swell height is proportional to the square of the swell pitch, the swell height is proportional to the distance from the imaginary straight line O as below.
h ∝ δx² ∝ x

A specific formation method of the segment electrodes 41b-41e is described below. Referring to Fig. 18, a circle C1 serving as an outer diameter of the piezoelectric element 40 is first drawn. A approximate circle C2 is next drawn by connecting points on lines drawn normal to each point on the circle C1, the points to be connected positioned at 0.8x^{0.5} of the extension of each normal line inside the circle C1. In a similar process, approximate circles C3, C4 and C5 are drawn. The shapes of the segment electrodes 41b-41e are thus determined.

### Embodiment 4

Fig. 20 illustrates a piezoelectric micro pump B in accordance with a fourth embodiment of the present invention. In the first - third embodiments, the piezoelectric element is arranged facing the substrate as a fixed plate. In the fourth embodiment, two piezoelectric elements 50 and 60 are arranged facing each other. In this example, outer circular portions of the piezoelectric elements 50 and 60 are bonded together. The piezoelectric element 50 as one element includes at the center thereof an outlet hole 51 and the piezoelectric element 60 as the other element includes inlet holes 61 on the outer circular portion thereof. The piezoelectric micro pump B suctions the fluid from the bottom side thereof, and ejects the fluid through the center of the top side thereof. In this case, the volume of the pocket S holding the fluid is twice as large as the volume with the fixed plate employed. The amount of flow of the fluid is advantageously increased. Both the inlet hole and the outlet hole may be arranged on one of the piezoelectric element 50 and the piezoelectric element 60.

### Embodiment 5

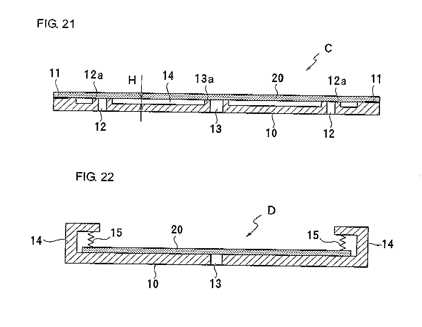

Fig. 21 illustrates a piezoelectric micro pump C of a fifth embodiment of the present invention. As the first embodiment, the fifth embodiment includes the piezoelectric element 20 with the outer circular portion thereof bonded to the substrate 10 with the adhesive agent 11. During no voltage application period (non-driving period) of the piezoelectric element 20, the surface of the piezoelectric element 20 is not entirely in contact with the substrate 10, and a gap 14 is caused between the substrate 10 and the piezoelectric element 20 in an area other than flow passage ports 12 and 13 of the substrate 10. The height H of the gap 14 is smaller than the amplitude of the piezoelectric element 20. During no-voltage application period, the piezoelectric element 20 is in contact with ring valve seats 12a and 13a projected surrounding the flow passage ports 12 and 13, and the surface pressure acting on the ring valve seats 12a and 13a is increased. Sealing performance of the flow passage ports 12 and 13 is thus increased. In this case, as well, the height of the gap 14 is smaller than the amplitude of the piezoelectric element 20, and the fluid is suctioned at a high pressure and then ejected at a high pressure.

### Embodiment 6

Fig. 22 illustrates a piezoelectric micro pump D of a sixth embodiment of the present invention. In the sixth embodiment, a holder 14 is formed on the substrate 10. Elastic members 15 elastically support the outer circular portion of the piezoelectric element 20 against the substrate 10. In this case, the outer circular portion of the piezoelectric element 20 is not rigidly fixed, and the edge of the outer circular portion of the piezoelectric element 20 is also bendable. For this reason, a more amount of fluid can be suctioned along the outer circular portion of the piezoelectric element 20, and an ejection amount of fluid is increased.

The above-described embodiments have a multilayer structure in which two piezoelectric layers are laminated as a piezoelectric element. Alternatively, three or more piezoelectric layers may be laminated. The use of a large number of thin layers allows a lower application voltage to be used.
One multilayer structure is produced by firing each piezoelectric layer having a single layer structure, forming electrodes on the top and bottom surfaces of each piezoelectric layer, and then bonding the piezoelectric layers together. Another multilayer structure is produced by laminating a plurality of ceramic green sheets, each having electrodes, and then firing the laminate.
In the above-described embodiments, the fluid conveyance device of the present invention is applied as a micro pump for conveying a compressible fluid such as the air. The fluid conveyance device may be applied to a noncompressible fluid such as a liquid.

### Brief Description of the Drawings

[Fig. 1] Fig. 1 is a perspective view generally illustrating a piezoelectric micro pump in accordance with a first embodiment of the present invention.
[Fig. 2] Fig. 2 is an exploded perspective view of the piezoelectric micro pump illustrated in Fig. 1.
[Fig. 3] Fig. 3 is a sectional view taken along line III-III in Fig. 1.
[Fig. 4] Fig. 4 illustrates a cross section and a wiring of a piezoelectric element for use in the piezoelectric micro pump illustrated in Fig. 1.
[Fig. 5] Fig. 5 illustrates an electrode pattern of the piezoelectric element illustrated in Fig. 4.
[Fig. 6] Fig. 6 illustrates phases of voltages applied to the piezoelectric element illustrated in Fig. 4.
[Fig. 7] Fig. 7 is an analysis diagram illustrating displacements of the piezoelectric elements at each phase when the voltages illustrated in Fig. 6 are applied.
[Fig. 8] Fig. 8 illustrates a change in the volume of a central pocket with the voltages illustrated in Fig. 6 applied.
[Fig. 9] Fig. 9 is a sectional view illustrating displacements of the piezoelectric element with an outer circular portion of the piezoelectric element fixed to a substrate.
[Fig. 10] Fig. 10 illustrates an example of the electrode structure that routes a segment electrode illustrated in Fig. 5 to the outside.
[Fig. 11] Fig. 11 illustrates another example of the electrode structure that routes the segment electrode illustrated in Fig. 5 to the outside.
[Fig. 12] Fig. 12 illustrates an electrode pattern of a piezoelectric element in accordance with a second embodiment of the present invention.
[Fig. 13] Fig. 13 illustrates a cross section and a wiring of the piezoelectric element illustrated in Fig. 12.
[Fig. 14] Fig. 14 illustrates phases of voltages applied to the piezoelectric element illustrated in Fig. 12.
[Fig. 15] Fig. 15 illustrates an example of the electrode structure that routes the segment electrode illustrated in Fig. 12 to the outside.
[Fig. 16] Fig. 16 illustrates another example of the electrode structure that routes the segment electrode illustrated in Fig. 12 to the outside.
[Fig. 17] Fig. 17 illustrates an electrode pattern of a piezoelectric element in accordance with a third embodiment.
[Fig. 18] Fig. 18 illustrates a design method of the electrode pattern of the piezoelectric element illustrated in Fig. 17.
[Fig. 19] Fig. 19 illustrates a displacement of the piezoelectric element illustrated in Fig. 17.
[Fig. 20] Fig. 20 is a sectional view of a displacement of a piezoelectric micro pump of a fourth embodiment of the present invention.
[Fig. 21] Fig. 21 is a sectional view of a piezoelectric micro pump of a fifth embodiment of the present invention.
[Fig. 22] Fig. 21 is a sectional view of a piezoelectric micro pump of a sixth embodiment of the present invention. Reference Numerals

A-D Piezoelectric micro pumps
1 Voltage application means
10 Substrate (fixed plate)
11 Adhesive agent
12 Inlet port
13 Outlet port
20 Piezoelectric element
21a and 21b Piezoelectric layers
22 Full-surface electrode
23a-23e Segment electrodes
30 Piezoelectric element
31a and 31b Piezoelectric layers
32a-32c and 33a-33c Segment electrodes

## Claims

1. A fluid conveyance device including a substrate, and a disk-like piezoelectric element arranged in a bendable fashion on the substrate,
wherein a plurality of circular concentric segment electrodes are provided on the piezoelectric element,
wherein voltage application means applying voltage to the segment electrodes with the voltage successively shifted in phase is arranged, and
wherein the voltages are applied to the segment electrodes with the phases thereof shifted to cause a ring wavy deformation on the piezoelectric element and move in a radial direction a ring pocket caused between the piezoelectric element and the substrate so that a fluid is conveyed between an outer circular potion and a central portion of the substrate.

2. The fluid conveyance device according to claim 1, wherein a first flow passage port is formed on the central portion of one of the substrate and the piezoelectric element, and a second flow passage port is formed on the outer circular portion of one of the substrate and the piezoelectric element or between the outer circular portions of both the substrate and the piezoelectric element.

3. The fluid conveyance device according to claim 2, wherein the outer circular portion of the piezoelectric element is fixed to the substrate, and wherein the first flow passage port and the second flow passage port are closed by the piezoelectric element and the substrate when no voltage is applied to the piezoelectric element.

4. The fluid conveyance device according to claim 3, wherein the full surface of the piezoelectric element is in contact with the full surface of the substrate when no voltage is applied to the piezoelectric element.

5. The fluid conveyance device according to one of claims 1 through 4, wherein the piezoelectric element is a multilayer type in which at least three circular concentric segment electrodes and a full-surface nonsegmented electrode are alternately laminated with a piezoelectric layer interposed therebetween.

6. The fluid conveyance device according to one of claims 1 through 4, wherein the piezoelectric element is a multilayer type in which a plurality of first circular concentric segment electrodes and a plurality of second segment electrodes are alternately laminated with a piezoelectric layer interposed therebetween, and wherein the second segment electrodes are concentric with the first segment electrodes and gaps between the second segment electrodes are alternately formed in a radial direction with a gap between the first segment electrodes.

7. A fluid conveyance device including a substrate, and a disk-like piezoelectric element arranged in a bendable fashion on the substrate,
wherein a plurality of generally circular segment electrodes decentered to one side are formed on the piezoelectric element,
wherein voltage application means applying voltage to the segment electrodes with the voltage successively shifted in phase is arranged, and
wherein the voltages are applied to the segment electrodes with the phase thereof shifted to cause a ring wavy deformation on the piezoelectric element and move in a radial direction a ring pocket caused between the piezoelectric element and the substrate so that a fluid is conveyed between an outer circular potion and a central portion of the device.

8. The fluid conveyance device according to claim 7, wherein each gap between the segment electrodes is set to be substantially proportional to the square root of a distance to an imaginary straight line on an outside circle of the piezoelectric element.

9. The fluid conveyance device according to one of claims 1 through 8, wherein the substrate is made of a piezoelectric element with the same structure as the piezoelectric element, and the voltages of the same phase are applied to the segment electrodes facing each other on the piezoelectric element with the phase of the voltage successively shifted to cause symmetrically a ring wavy deformation on the pair of piezoelectric elements and move in a radial direction a ring pocket caused between the pair of piezoelectric elements so that a fluid is conveyed.
